# EUROPÄISCHE PATENTANMELDUNG

(11) **EP 1 233 372 A1**
(43) Veröffentlichungstag der Anmeldung: **21.08.2002**
(21) Anmeldenummer: 02100018.7
(22) Anmeldetag: 16.01.2002
(51) Int. Cl.: G06K 19/073, G07F 7/10, G11C 16/22, H01L 23/58

(54) **Schaltung und Verfahren zum Schützen einer Chipanordnung vor Manipulation und/oder vor Missbrauch**

(30) Priorität: 18.01.2001 DE 10101995
(71) Anmelder: Philips Corporate Intellectual Property GmbH, 52066 Aachen (DE); Koninklijke Philips Electronics N.V., 5621 BA Eindhoven (NL)
(72) Erfinder: Bretschneider, Ernst, Weisshausstrasse 2 52066, Aachen (DE); Einfeldt, Walter, Weisshausstrasse 2 52066 Aachen (DE); Fuhrmann, Johann, Weisshausstrasse 2 Aachen, 52066 (DE)
(74) Vertreter: Volmer, Georg, Dipl.-Ing.

(57) **Zusammenfassung**

Um eine elektrische oder elektronische Schaltungsanordnung (100) sowie ein Verfahren zum Schützen mindestens einer Chipanordnung (200), beispielsweise mindestens einer (Halbleiter-)Chipanordnung, insbesondere mindestens einer Controllerchipanordnung für eine Chipkarte oder Smart Card, vor Manipulation und/oder vor Missbrauch zu schaffen, bei denen ein optischer Angriff mittels Lichteinstrahlung auf eine Controllerchipanordnung selbst sowie auf eine die Controllerchipanordnung bedeckende, zum Schützen der integrierten Schaltung vor äußeren Einflüssen vorgesehene dielektrische Abdeckung, insbesondere Isolierungsschicht und/oder Passivierungsschicht und/oder weitere Schutzschicht, sowohl von der Vorderseite der Controllerchipanordnung her als auch von der im wesentlichen ungeschützten Rückseite der Controllerchipanordnung her zuverlässig und nachhaltig abgewehrt werden kann, werden
- mindestens eine insbesondere optosensitive Detektoreinheit (10), deren Ausgangsspannung (Vₐᵤₛ) ein Maß für den Lichteinfall (Li) auf die Detektoreinheit (10) ist; und
- mindestens eine der Detektoreinheit (10) nachgeschaltete Komparatoreinheit (20) zum Vergleichen der Ausgangsspannung (Vₐᵤₛ) der Detektoreinheit (10) mit einer Referenzspannung (V_{ref}), wobei die zu schüzenden Daten und/oder Funktionen der Chipanordnung (200) bei Vorliegen einer beim Vergleichen der Ausgangsspannung (Vₐᵤₛ) der Detektoreinheit (10) mit der Referenzspannung (V_{ref}) auftretenden Fehlermeldung temporär oder permanent blockierbar und/oder löschbar (L) und/oder sperrbar (S) und/oder unterbrechbar sind,
vorgeschlagen.

## Beschreibung

### Technisches Gebiet

Die vorliegende Erfindung betrifft eine elektrische oder elektronische Schaltungsanordnung sowie ein Verfahren zum Schützen mindestens einer Chipanordnung, beispielsweise mindestens einer (Halbleiter-)Chipanordnung, insbesondere mindestens einer Controllerchipanordnung für eine Chipkarte oder Smart Card, vor Manipulation und/oder vor Missbrauch.

### Stand der Technik

Generell gilt im Zusammenhang mit dem Schutz vor Manipulation und/oder vor Missbrauch, dass die Sicherheitsanforderungen insbesondere auf dem Gebiet der Smart Card-Chiptechnik mit wachsender Verbreitung der Smart Cards laufend zunehmen, wie etwa aus dem Beispiel der Bankkarten, der Krankenkassenkarten oder auch diverser Sicherheitschipkarten ersehen werden kann. Die Gemeinsamkeit aller derartigen Chipkarten beruht auf der Speicherung sensibler Daten, die einzig und allein für den autorisierten, das heißt berechtigten Benutzer der Chipkarte im zuvor definierten Rahmen zugänglich sein sollen. In diesem Zusammenhang ist es in der Regal das Ziel unbefugter Personen, Informationen aus der Chipkarte, insbesondere aus der Controllerchipanordnung, zu lesen bzw. die funktionalen Bausteine des Chips zu analysieren, um die Chipkarte manipulativ und/oder missbräuchlich einsetzen zu können.

Mithin ist es den heutzutage auf dem Markt befindlichen wie auch den zukünftigen Controllerchipanordnungen gemeinsam, dass auf ihnen sicherheitsrelevante Daten und/oder Funktionen gespeichert sind, die vor missbräuchlicher Benutzung durch unautorisierte Dritte unbedingt zu schützen sind Eine manipulative Möglichkeit, unbefugt Informationen über den Aufbau, die Daten und/oder die Funktionen einer Controllerchipanordnung zu erhalten, bietet die Bestrahlung der Controllerchipanordnung mit elektromagnetischen Wellen, im speziellen mit Licht; dieses potentielle Angriffsszenario ist im Regelfall darauf gerichtet, die Controllerchipanordnung in einen Zustand zu bringen, in dem ein mehr oder minder einfacher Zugang zu sicherheitsrelevanten Daten und/oder Funktionen möglich ist; auf diese Weise können nicht zuletzt auch durch Software definierte Schranken zumindest teilweise unbefugterweise überwunden werden.

Um nun die aus diesen Missbrauchsgefahren resultierenden Sicherheitsanforderungen erfüllen zu können, wird ein Konzept benötigt, das eine Kombination aus aktiven und passiven Sicherheitsstrukturen, wie etwa aus (Licht-)Sensoren und aus Passivierungsschichten, in sich vereint. In diesem Zusammenhang ist ein Anordnen von Lichtdetektoren für die Anwendung in integrierten Schaltungen für Chipkarten beispielsweise aus der Druckschrift US 4 952 796 oder auch aus der Druckschrift WO 98/22905 A1 bereits bekannt. Während aus der Druckschrift US 4 952 796 eine mit Vorspannungselement versehene Schaltung hervorgeht, die eine Diode als lichtempfindliches Detektorbauteil enthält, offenbart die Druckschrift WO 98/22905 A1 einen bestimmte Eigenschaften bereitstellenden Lichtdetektor mit zwei Feldeffekttransistoren.

### Darstellung der Erfindung: Aufgabe, Lösung, Vorteile

Ausgehend von den konventionellen Anordnungen liegt der vorliegenden Erfindung die Aufgabe zugrunde, eine elektrische oder elektronische Schaltungsanordnung sowie ein Verfahren der eingangs genannten Art bereitzustellen, bei denen ein optischer Angriff mittels Einstrahlung elektromagnetischer Wellen, insbesondere mittels Licht, auf eine Controllerchipanordnung selbst sowie auf eine die Controllerchipanordnung bedeckende, zum Schützen der integrierten Schaltung vor äußeren Einflüssen vorgesehene dielektrische Abdeckung, insbesondere Isolierungsschicht und/oder Passivierungsschicht und/oder weitere Schutzschicht, sowohl von der Vorderseite der Controllerchipanordnung her als auch von der im wesentlichen ungeschützten Rückseite der Controllerchipanordnung her zuverlässig und nachhaltig abgewehrt werden kann.

Diese Aufgabe wird durch die im Anspruch 1 für eine elektrische oder elektronische Schalttmgsanordnung zum Schützen mindestens einer Chipanordnung vor Manipulation und/oder vor Missbrauch angegebenen Merkmale sowie durch die im Anspruch 28 für ein Verfahren zum Schützen mindestens einer Chipanordnung vor Manipulation und/oder vor Missbrauch angegebenen Merkmale gelöst. Vorteilhafte Ausgestaltungen und zweckmäßige Weiterbildungen der vorliegenden Erfindung sind in den jeweiligen Unteransprüchen gekennzeichnet.

Mithin basiert die Lehre der vorliegenden Erfindung auf der Bedeckung der Chipanordnung mit mindestens einer schwer entfernbaren, im wesentlichen lichtdichten dielektrischen Schicht und auf dem zusätzlichen Schutz dieser dielektrischen Schicht durch mindestens eine Detektoreinheit (im folgenden "optosensitive Detektoreinheit" genannt), durch die zusätzlich zu Angriffen auf die dielektrische Schicht auch Angriffe von der im wesentlichen ungeschützten Rückseite der Chipanordnung her abgewehrt werden können. Diese optosensitive Detektoreinheit ist demzufolge in das Sicherheitskonzept der Chipanordnung mit dem Ziel eingebunden, die vorgenannten potentiellen Angriffsmöglichkeiten abzuwehren bzw. zumindest substantiell zu erschweren.

Hierbei liegt den Angriffsmöglichkeiten im wesentlichen das gleiche physikalische Prinzip wie der optosensitiven Detektoreinheit selbst zugrunde: Die Bestrahlung mit Licht, das heißt mit Photonen geeigneter Frequenz bzw. Energie kann in Halbleitersperrschichten sogenannte "Elektron-Loch-Paare" erzeugen und somit den Strom durch diese Schichten verändern. Dies kann einerseits Fehlfunktionen der zu schützenden Chipanordnung bewirken und andererseits die optosensitive Detektoreinheit gerade auslösen.

Der Schutz beim Auslösen der optosensitiven Detektoreinheit besteht in diesem Zusammenhang im Verhindern des Zugriffs auf die sicherheitsrelevanten Daten und/oder Funktionen, und zwar durch partielles oder vollständiges Sperren der Daten und/oder Funktionen der Chipanordnung, wobei diese Sperrung temporär, das heißt auf die Dauer der Lichtbestrahlung beschränkt, oder permanent sein kann; in letzterem Falle wird die betroffene Chipanordnung dann dauerhaft unbrauchbar. Eine weitere Schutzmaßnahme ist im Löschen der sicherheitsrelevanten Daten und/oder Funktionen zu sehen, wodurch die betroffene Chipanordnung ebenfalls dauerhaft unbrauchbar wird.

Um auch einem Angriff durch partielles Entfernen der im wesentlichen lichtdichten dielektrischen Abdeckung begegnen zu können, können in zweckmäßiger Ausgestaltung der vorliegenden Erfindung auch mehrere oder viele optosensitive Detektoreinheiten verteilt auf der Chipanordnung untergebracht werden.

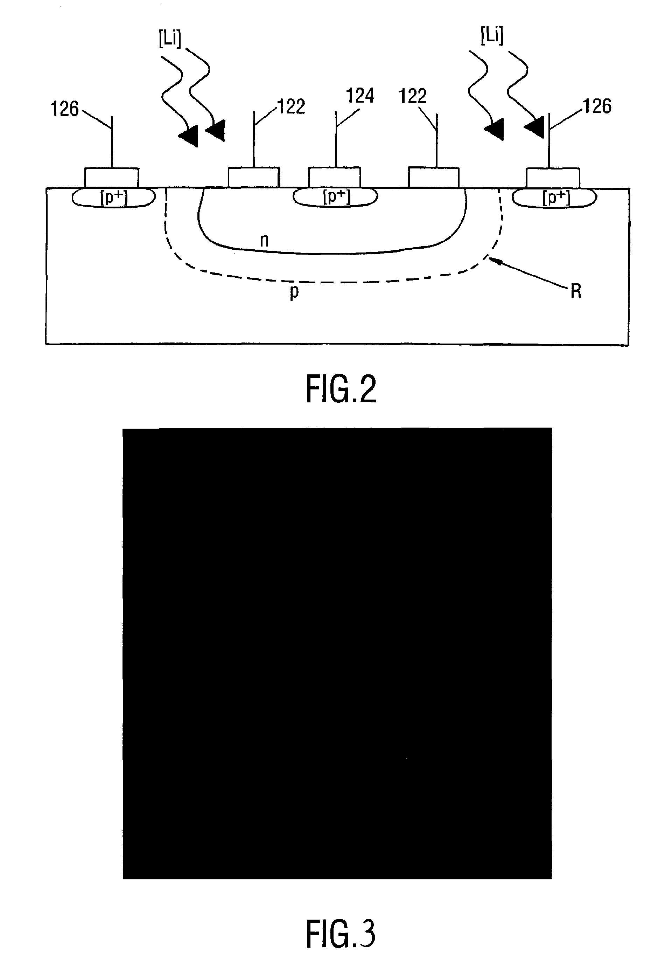

Gemäß einer besonders erfinderischen Weiterbildung kann eine Besonderheit der optosensitiven Detektoreinheit darin bestehen, dass als lichtempfindliches Element mindestens ein bipolarer Transistor (Figur 2) eingesetzt wird, der in einem Herstellungsprozess für normale digitale Schaltungen ohne zusätzlichen Aufwand zur Verfügung gestellt werden kann; insbesondere sind hierfür keinerlei zusätzliche Masken oder Diffusionen erforderlich.

In vorteilhafter Weise können diese bipolaren Transistoren im Gegensatz zu konventionellen Phototransistoren relativ tief unter der Oberfläche der Chipanordnung und mithin relativ exakt auf Höhe bzw. in der Ebene der zu schürzenden Daten und/öder Funktionen angeordnet werden; demzufolge kann nur Licht, das durch die diversen darüberliegenden Oxidschichten bis an diese bipolaren Transistoren vordringt, zur Auslösung führen, was den möglicherweise vor Aufbringen der im wesentlichen lichtdichten Schutzschicht erfolgenden Test der integrierten Schaltungen auf dem Wafer wesentlich vereinfacht.

Gemäß einer bevorzugten Ausrührungsform der vorliegenden Erfindung weist die optosensitive Detektoreinheit zwei Einheiten auf, wobei in einer ersten Einheit die Lichtdetektion erfolgt. So kann der Ausgang der ersten Einheit im Ruhezustand (,das heißt kein elektromagnetischer Strahlungseinfall vorhanden) ein relatives hohes elektrisches Potential aufweisen (--> "High-Signal"); trifft nun Licht auf die optosensitive Detektoreinheit, so sinkt die Ausgangsspannung in Abhängigkeit von der Intensität und von der Wellenlänge des einfallenden Lichts (hierbei gilt der Zusammenhang: je größer die Wellenlänge, das heißt je kleiner die Frequenz (beispielsweise infrarote elektromagnetische Strahlung) beim Bestrahlen der optosensitiven Detektoreinheit ist, desto größer ist die Wahrscheinlichkeit, dass die Photonen sehr tief in das Material der optosensitiven Detektoreinheit eindringen können; dies bedeutet umgekehrt, dass für Photonen mit kleiner Wellenlänge, das heißt mit großer Frequenz eine relativ hohe Wahrscheinlichkeit besteht, in einer der äußeren Schichten absorbiert zu werden).

Das vorbeschriebene Absinken der Ausgangsspannung kann mittels mindestens einer Komparatoreinheit registriert werden, die in einer zweiten Einheit untergebracht ist. Sinkt nun der Wert der Ausgangsspannung der ersten Einheit unter den Wert einer Vergleichs- oder Referenzspannung, dann signalisiert die Komparatoreinheit mindestens einer nachgeschalteten Auswertelogik den Zustand "Licht detektiert". Die Lichtintensität, bei der die optosensitive Detektoreinheit schaltet, kann in diesem Zusammenhang durch geeignete Wahl des Arbeitspunktes und/oder durch geeignete Wahl der Referenzspannung eingestellt werden.

Zusammenfassend lässt sich feststellen, dass durch die vorliegende Erfindung eine elektrische oder elektronische Schaltungsanordnung sowie ein Verfahren zum Schützen mindestens einer Chipanordnung vor Manipulation und/oder vor Missbrauch zur Verfügung gestellt sind, bei denen - in Abgrenzung zur Einrichfung gemäß der Druckschrift US 4 952 796 oder auch zur Einrichtung gemäß der Druckschrift WO 98/22905 A1 - ein optischer Angriff mittels Lichteinstrahlung auf eine Chipanordnung selbst sowie auf eine die Chipanordnung bedeckende, zum Schützen der integrierten Schaltung vor äußeren Einflüssen vorgesehene dielektrische Abdeckung, insbesondere Isolierungsschicht und/oder Passivierungsschicht und/oder weitere Schutzschicht, sowohl von der Vorderseite der Chipanordnung her als auch von der im wesentlichen ungeschützten Rückseite der Chipanordnung her zuverlässig und nachhaltig abgewehrt werden kann.

Die vorliegende Erfindung betrifft des weiteren eine Karte, insbesondere Chipkarte oder Smart Card, aufweisend mindestens eine elektrische oder elektronische Schaltungsanordnung gemäß der vorstehend dargelegten Art.

Die vorliegende Erfindung betrifft schließlich eine Chipanordnung, beispielsweise (Halbleiter-)Chipanordnung, insbesondere Controllerchipanordnung für eine Chipkarte oder Smart Card, aufweisend
- mindestens eine, vorzugsweise mehrere oder viele insbesondere optosensitive Detektoreinheiten gemäß der vorstehend dargelegten Art; und
- mindestens eine Verknüpfungslogikeinheit zum Verknüpfen der Detektoreinheiten.

### Kurze Beschreibung der Zeichnungen

Weitere Ausgestaltungen, Merkmale und Vorteile der vorliegenden Erfindung werden nachstehend anhand des durch die Figuren 1 bis 7 veranschaulichten Ausführungsbeispiels näher erläutert.

Es zeigt:
- Fig. 1: ein Ausführungsbeispiel einer Schaltungsanordnung gemäß der vorliegenden Erfindung, in schematischer Prinzipdarstellung;
- Fig. 2: den prinzipiellen Aufbau eines Phototransistors, im Querschnitt;
- Fig. 3: ein Ersatzschaltbild für die Abgrenzung eines bipolaren Transistors von einer Photodiode;
- Fig. 4: eine erste Ausgestaltungsmöglichkeit der Einbindung optosensitiver Detektoreinheiten gemäß der vorliegenden Erfindung in das Sicherheitskonzept einer Smart Card-Controllerchipanordnung;
- Fig. 5: eine zweite Ausgestaltungsmöglichkeit der Einbindung optosensitiver Detektoreinheiten gemäß der vorliegenden Erfindung in das Sicherheitskonzept einer Smart Card-Controllerchipanordnung;
- Fig. 6: eine dritte Ausgestaltungsmöglichkeit der Einbindung optosensitiver Detektoreinheiten gemäß der vorliegenden Erfindung in das Sicherheitskonzept einer Smart Card-Controllerchipanordnung; und
- Fig. 7: eine vierte Ausgestaltungsmöglichkeit der Einbindung optosensitiver Detektoreinheiten gemäß der vorliegenden Erfindung in das Sicherheitskonzept einer Smart Card-Controllerchipanordnung.

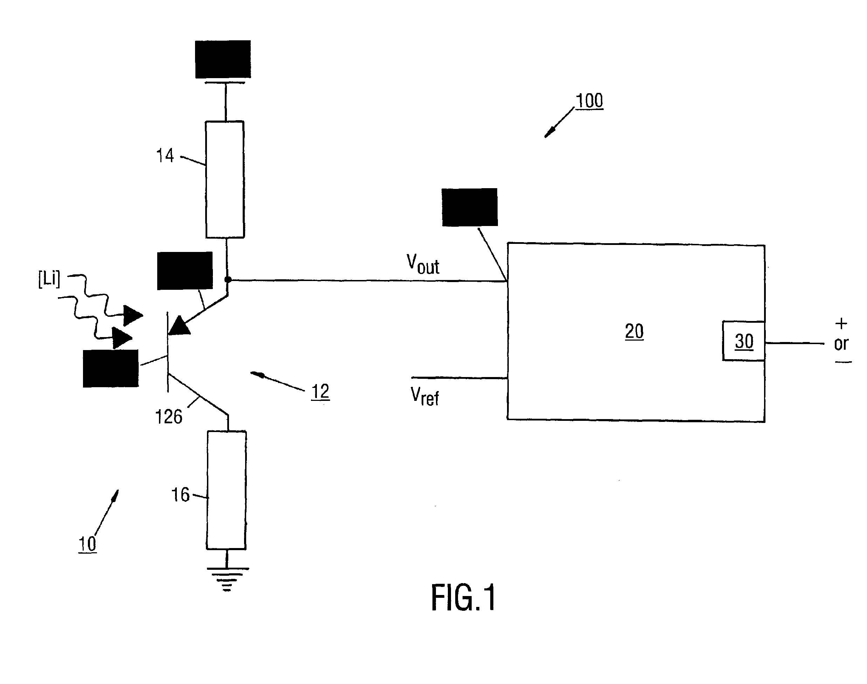

Gleiche oder ähnliche Ausgestaltungen, Elemente oder Merkmale sind in den Figuren 1 bis 7 mit identischen Bezugszeichen versehen.

### Bester Weg zur Ausführung der Erfindung

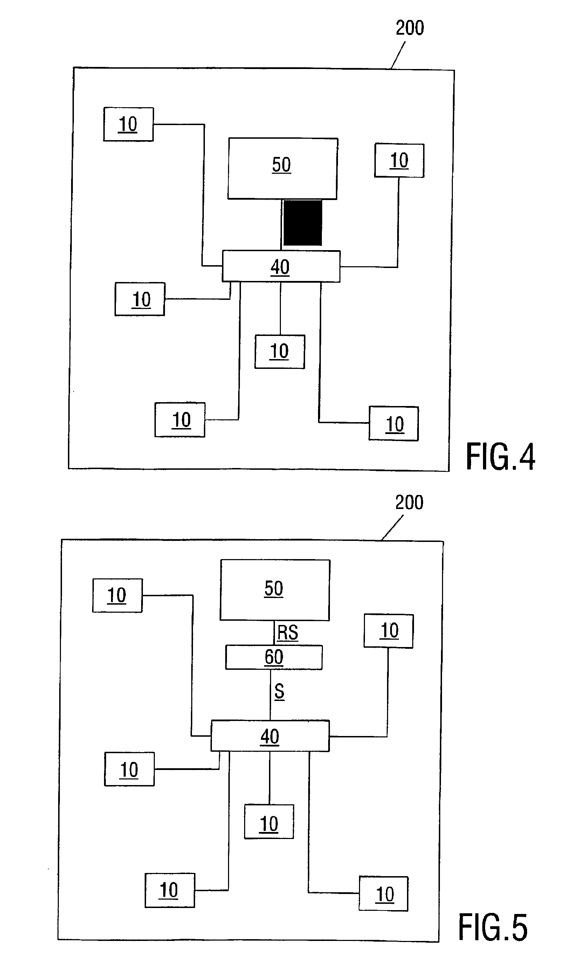

Die in Figur 1 dargestellte, in eine Chipkarte oder Smart Card zu implementierende und zu integrierende Schaltunganordnung 100 schützt eine in den Figuren 4 bis 7 abgebildete Silizium-Controllerchipanordnung 200 der Chipkarte oder der Smart Card vor Manipulation und/oder vor Missbrauch.

Um nun die hohen Sicherheitsanforderungen auf dem Gebiet der Smart Card-Chiptechnik erfüllen zu können, basiert das Konzept des Ausführungsbeispiels gemäß der vorliegenden Erfindung auf einer Kombination optosensitiver Detektoreinheiten 10 und einer zum Schützen der Chipanordnung 200 vor äußeren Einflüssen vorgesehenen, schwer entfernbaren dielektrischen Sicherheitsabdeckung in Form einer lichtundurchlässigen Passivierungsschicht. Wird nun die Vorderseite der Chipanordnung 200 mit elektromagnetischen Wellen bestrahlt wird, absorbiert und/oder reflektiert die Sicherheitsabdeckung diese Lichtstrahlung.

Die Bestrahlung der Chipanordnung 200 mit Licht von der Rückseite her ist im Regelfall nur möglich, wenn die Chipanordnung 200 von ihrem schichtförmigen Trägersubstrat aus isolierendem Material abgelöst wird. Erfolgt nun nach Ablösen der Chipanordnung 200 vom schichtförmigen Trägersubstrat eine derartige Bestrahlung der Chipanordnung 200 mit Licht von der Rückseite her, so registriert dies die optosensitive Detektoreinheit 10 und gibt eine digitale Fehlermeldung aus. Diese Fehlermeldung führt dazu, dass beispielsweise der Zugang zur Speichereinheit der Chipanordnung 200 oder auch die gesamte Chipanordnung 200 gesperrt wird (im wesentlichen dieselbe Konsequenz hat auch ein Entfernen der Sicherheitsabdeckung).

Mithin dient die optosensitive Detektoreinheit 10 dem Schutz gegen unautorisiertes, unbefugtes und/oder unerlaubtes Bestrahlen der Chipanordnung 200 mit Licht unterschiedlicher Wellenlänge, um Ladungen zu generieren, die den Arbeitsmodus der Chipanordnung 200 verändern könnten. Im speziellen ist die optosensitive Detektoreinheit 10 unter der Oberfläche der Chipanordnung 200, und zwar im wesentlichen in der Ebene der zu schützenden Daten und Funktionen, vorgesehen, wobei die Ausgangsspannung Vₐᵤₛ (vgl. Figur 1) der Detektoreinheit 10 ein Maß für den Lichteinfall auf die Detektoreinheit 10 ist. Der Detektoreinheit 10 ist eine Komparatoreinheit 20 nachgeschaltet, mittels derer die Ausgangsspannung Vₐᵤₛ der Detektoreinheit 10 mit einer Referenzspannung V_{ref} (vgl. Figur 1) verglichen wird.

Die zu schützenden Daten und/oder Funktionen der Chipanordnung 200 werden bei Vorliegen einer beim Vergleichen der Ausgangsspannung Vₐᵤₛ der Detektoreinheit 10 mit der Referenzspannung V_{ref} auftretenden Fehlermeldung temporär oder permanent blockiert und/oder gelöscht und/oder gesperrt und/oder unterbrochen (vgl. die nachstehenden Erläuterungen zu den vier Ausgestaltungsmöglichkeiten gemäß den Figuren 4 bis 7).

Diese optosensitive Detektoreinheit 10 weist als Hauptelement ein Feld oder "array" räumlich verteilt angeordneter bipolarer Transistoren 12 in Form von pnp-Transistoren auf (in Figur 1 ist exemplarisch ein derartiger pnp-Transistor dargestellt).

Hierbei nutzt die eingesetzte optosensitive Detektoreinheit 10 die lichtempfindlichen Eigenschaften von Halbleiter-Transistoren, insbesondere von Silizium-Transistoren, aus, denn der pnp-Transistor liefert eine Verstärkung des Photostroms. Wie der Darstellung der Figur 1 entnehmbar ist, ist der Emitter 124 des bipolaren Transistors 12 über einen Versorgungswiderstand an die Versorgungsspannung V_{dd} angeschlossen, wohingegen der Kollektor 126 des bipolaren Transistors 12 über einen Referenzwiderstand 16 mit dem Erdpotential verbunden ist.

Die Basis des bipolaren Transistors 12 ist nicht angeschlossen. Da nun die einfallende Lichtstrahlung (Li) im wesentlichen auf den Übergang zwischen der Basis 122 des bipolaren Transistors 12 und dem Kollektor 126 des bipolaren Transistors 12 fällt und sowohl im Gebiet der Basis 122 als auch im angrenzenden Gebiet des Kollektors 126 Elektron-Loch-Paare erzeugt, saugt der in Sperrrichtung gepolte Übergang zwischen der Basis 122 und dem Kollektor 126 Löcher ab, drückt jedoch auch Elektronen in die Basis 122. Hierdurch wird die Basis 122 gegenüber dem Emitter 124 negativer, und der Übergang zwischen der Basis 122 und dem Emitter 124 wird stärker in Durchlassrichtung getrieben; der Emitterstrom und somit auch der Kollektorstrom werden erhöht, wobei der Phototransistor infolge von Minoritätsträgereffekten in der Basis 122 nur von limitierter Geschwindigkeit ist.

Da der Kollektorübergang im Phototransistor im Prinzip wie eine Photodiode arbeitet, kann zur Modellbildung der bipolare Transistor 12 von der Photodiode getrennt werden, was im Ersatzschaltbild gemäß Figur 3 veranschaulicht ist. Der Emitter 124 des bipolaren Transistors 12 ist mit dem für die Ausgangsspannung Vₐᵤₛ vorgesehenen Eingang 22 der Komparatoreinheit 20 verbunden, so dass die Ausgangsspannung Vₐᵤₛ der Detektoreinheit 10 mit steigender Wellenlänge und/oder mit wachsender Intensität des einfallenden Lichts sinkt. Im speziellen generiert eine der Komparatoreinheit 20 nachgeschaltete Auswerteeinheit 30 die Fehlermeldung, wenn der Wert der Ausgangsspannung Vₐᵤₛ der Detektoreinheit 10 unter den Wert der Referenzspannung V_{ref} sinkt. Der Arbeitspunkt der Detektoreinheit 10 und der Wert der Referenzspannung V_{ref} sind hierbei einstellbar, so dass durch den Einsatz der Komparatoreinheit 20 sämtliche Freiheiten bestehen, die Schaltschwelle einzustellen.

Wie aus den vorstehenden Erläuterungen hervorgeht, spielt die Erzeugung von Elektron-Loch-Paaren im Rahmen der vorliegenden Erfindung eine wesentliche Rolle In Anbetracht des als Halbleitermaterial für die Phototransistoren eingesetzten Siliziums umfasst die spektrale Empfindlichkeit beim Ausführungsbeispiel gemäß der vorliegenden Erfindung einen relativ breiten Wellenlängenbereich von etwa 450 Nanometer bis etwa 1.050 Nanometer, wobei das Maximum bei einer Wellenlänge von etwa 800 Nanometer liegt.

Die Figuren 4 bis 7 schließlich zeigen vier Möglichkeiten der Einbindung optosensitiver Detektoreinheiten 10 gemäß der vorliegenden Erfindung in das Sicherheitskonzept einer Smart Card-Controllerchipanordnung 200. Gemeinsam sind diesen vier Ausgestaltungsformen jeweils sechs exemplarisch verteilte, die Smart Card-Controllerchipanordnung 200 gegen lichtinduzierte Angriffe sowohl von der Vorderseite her als auch von der Rückseite her zuverlässig und nachhaltig schützende Detektoreinheiten 10 (vgl. hierzu auch Figur 1) und jeweils eine Verknüpfungslogikeinheit 40, durch die die jeweils sechs Detektoreinheiten 10 miteinander verknüpft werden und durch die das Zusammenwirken der jeweils sechs Detektoreinheiten 10 gesteuert und koordiniert wird

Gemäß der ersten, anhand Figur 4 exemplarisch veranschaulichten Ausgestaltungsmöglichkeit erfolgt nun - im Wege eines "Reset" RS - eine vorübergehende oder temporäre Sperrung einer mit der Verknüpfungslogikeinheit 40 in Verbindung stehenden Kontrolllogikeinheit 50, wenn die Vorderseite und/oder die Rückseite der Smart Card-Controllerchipanordnung 200 bestrahlt wird; dies bedeutet mit anderen Worten, dass der Zugriff auf die sicherheitsrelevanten Daten und/oder Funktionen zumindest solange gesperrt wird, wie die Smart Card-Controllerchipanordnung 200 elektromagnetischer Strahlung ausgesetzt ist.

Gemäß der zweiten, anhand Figur 5 exemplarisch veranschaulichten Ausgestaltungsmöglichkeit erfolgt hingegen eine dauerhafte oder permanente Sperrung RS der Kontrolllogik 50, ausgelöst durch eine Sperrung S einer zwischen die Verknüpfungslogik 40 und die Kontrolllogik 50 geschalteten, einmal elektrisch programmierbaren Speichereinheit 60, wenn die Vorderseite und/oder die Rückseite der Smart Card-Controllerchipanordnung 200 bestrahlt wird; hierzu löst die Speichereinheit 60 mittels "Reset" RS eine dauerhafte Sperrung der Kontrolllogik 50 aus; dies bedeutet mit anderen Worten, dass der Zugriff auf die sicherheitsrelevanten Daten und/oder Funktionen auch dann noch gesperrt ist, wenn die Smart Card-Controllerchipanordnung 200 nicht mehr elektromagnetischer Strahlung ausgesetzt ist.

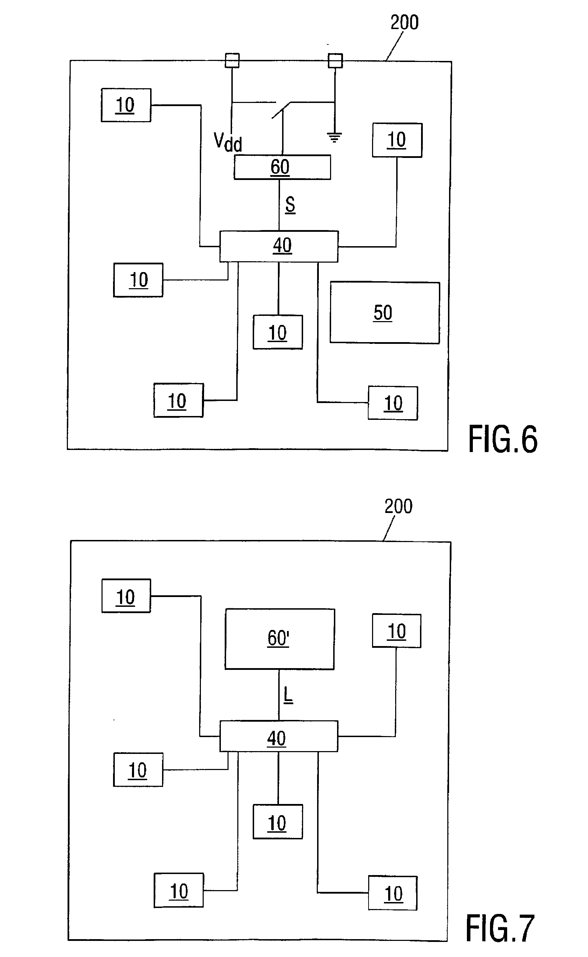

Gemäß der dritten, anhand Figur 6 exemplarisch veranschaulichten Ausgestaltungsmöglichkeit erfolgt eine dauerhafte oder permanente Sperrung der gesamten Smart Card-Kontrollerchipanordnung 200 durch einen Kurzschluss der Versorgungsspannung V_{dd}, ausgelöst durch die dauerhafte Sperrung S einer mit der Verknüpfungslogik 40 in Verbindung stehenden, einmal elektrisch programmierbaren Speichereinheit 60, wenn in manipulativer und missbräuchlicher Absicht versucht wird, im Wege der Lichteinstrahlung sicherheitsrelevante Daten und/oder Funktionen ausfindig zu machen, indem die Vorderseite und/oder die Rückseite der Smart Card-Controllerchipanordnung 200 bestrahlt wird; hierzu löst die Speichereinheit 60 einen dauerhaften Kurzschluss der Versorgungsspannung V_{dd} aus; dies bedeutet mit anderen Worten, dass der Zugriff auf die sicherheitsrelevanten Daten und/oder Funktionen auch dann noch gesperrt ist, wenn die Smart Card-Controllerchipanordnung 200 nicht mehr elektromagnetischer Strahlung ausgesetzt ist, weil die Versorgungsanschlüsse der betroffenen Smart Card-Controllerchipanordnung 200 dauerhaft kurzgeschlossen sind.

Gemäß der vierten, anhand Figur 7 exemplarisch veranschaulichten Ausgestaltungsmöglichkeit erfolgt schließlich eine Löschung L der sicherheitsrelevanten Daten und/oder Funktionen in einer mit der Verknüpfungslogikeinheit 40 in Verbindung stehenden EEPROM-Speichereinheit 60' (EEPROM = Electrically Erasable Programmable Read-Only Memory = elektrisch löschbarer, programmierbarer Festwertspeicher), wenn in manipulativer und missbräuchlicher Absicht versucht wird, im Wege der Lichteinstrahlung sicherheitsrelevante Daten und/oder Funktionen ausfindig zu machen, indem die Vorderseite und/oder die Rückseite der Smart Card-Controllerchipanordnung 200 bestrahlt wird. Bei dieser vierten Ausgestaltungsmöglichkeit wird die betroffene Smart Card-Controllerchipanordnung 200 mithin dadurch dauerhaft unbrauchbar, dass die sicherheitsrelevanten Daten und/oder Funktionen gelöscht werden.

### Bezugszeichenliste

- 100: elektrische oder elektronische Schaltungsanordnung
- 10: Detektoreinheit
- 12: bipolarer Transistor, insbesondere pnp-Transistor
- 122: Basis des bipolaren Transistors 12
- 124: Emitter des bipolaren Transistors 12
- 126: Kollektor des bipolaren Transistors 12
- 14: Versorgungswiderstand
- 16: Referenzwiderstand
- 20: Komparatoreinheit
- 22: Eingang der Komparatoreinheit 20
- 30: Auswerteeinheit
- 40: Verknüpfungslogikeinheit
- 50: Kontrolllogikeinheit
- 60: Speichereinheit, insbesondere elektrisch löschbare Speichereinheit
- 60': EEPROM-Speichereinheit
- 200: Chipanordnung, beispielsweise (Halbleiter-)Chipanordnung, insbesondere Controllerchipanordnung für Chipkarte oder für Smart Card
- L: Löschen
- Li: Licht
- R: Raumladungszone
- RS: Reset
- S: Sperren
- SiNO₂: Siliziumnitrit
- SiO₂: Siliziumdioxid
- Vₐᵤₛ: Ausgangsspannung
- V_{dd}: Versorgungsspannung
- V_{ref}: Referenzspannung

## Patentansprüche

1. Elektrische oder elektronische Schaltungsanordnung (100) zum Schützen mindestens einer Chipanordnung (200), beispielsweise mindestens einer (Halbleiter-) Chipanordnung, insbesondere mindestens einer Controllerchipanordnung für eine Chipkarte oder Smart Card, vor Manipulation und/oder vor Missbrauch,
**gekennzeichnet durch**
- mindestens eine insbesondere optosensitive Detektoreinheit (10), deren Ausgangsspannung (Vₐᵤₛ) ein Maß für den Lichteinfall (Li) auf die Detektoreinheit (10) ist; und
- mindestens eine der Detektoreinheit (10) nachgeschaltete Komparatoreinheit (20) zum Vergleichen der Ausgangsspannung (Vₐᵤₛ) der Detektoreinheit (10) mit einer Referenzspannung (V_{ref}), wobei die zu schützenden Daten und/oder Funktionen der Chipanordnung (200) bei Vorliegen einer beim Vergleichen der Ausgangsspannung (Vₐᵤₛ) der Detektoreinheit (10) mit der Referenzspannung (V_{ref}) auftretenden Fehlermeldung temporär oder permanent blockierbar und/oder löschbar (L) und/oder sperrbar (S) und/oder unterbrechbar sind

2. Schaltungsanordnung (100) gemäß Anspruch 1,
**dadurch gekennzeichnet,**
**dass** die Detektoreinheit (10)
- unter der Oberfläche der Chipanordnung (200), insbesondere unter mindestens einer Oxidschicht der Chipanordnung (200), und/oder
- im wesentlichen in der Ebene der zu schützenden Daten und/oder Funktionen
angeordnet ist.

3. Schaltungsanordnung (100) gemäß Anspruch 1 oder 2,
**dadurch gekennzeichnet,**
**dass** die Detektoreinheit (10) mindestens einen bipolaren Transistor (12), insbesondere mindestens einen pnp-Transistor, aufweist.

4. Schaltungsanordnung (100) gemäß Anspruch 3,
**dadurch gekennzeichnet,**
**dass** die Detektoreinheit (10) durch mehrere oder viele räumlich verteilt angeordnete bipolare Transistoren (12) gebildet ist.

5. Schaltungsanordnung (100) gemäß mindestens einem der Ansprüche 3 bis 4,
**dadurch gekennzeichnet,**
**dass** der Emitter (124) des bipolaren Transistors (12) mit dem für die Ausgangsspannung (Vₐᵤₛ) vorgesehenen Eingang (22) der Komparatoreinheit (20) verbunden ist.

6. Schaltungsanordnung (100) gemäß mindestens einem der Ansprüche 3 bis 5,
**dadurch gekennzeichnet,**
**dass** der Emitter (124) des bipolaren Transistors (12) über mindestens einen Versorgungswiderstand (14) an mindestens eine Versorgungsspannung (V_{dd}) angeschlossen ist.

7. Schaltungsanordnung (100) gemäß mindestens einem der Ansprüche 3 bis 6,
**dadurch gekennzeichnet,**
**dass** der Kollektor (126) des bipolaren Transistors (12) über mindestens einen Referenzwiderstand (16) mit dem Erdpotential oder mit dem Massepotential verbunden ist.

8. Schaltungsanordnung (100) gemäß mindestens einem der Ansprüche 3 bis 7,
**dadurch gekennzeichnet,**
**dass** im wesentlichen der Übergang zwischen der Basis (122) des bipolaren Transistors (12) und dem Kollektor (126) des bipolaren Transistors (12) zum Aufnehmen des auf die Detektoreinheit (10) einfallenden Lichts vorgesehen ist.

9. Schaltungsanordnung (100) gemäß mindestens einem der Ansprüche 1 bis 8,
**dadurch gekennzeichnet,**
**dass** die Ausgangsspannung (Vₐᵤₛ) der Detektoreinheit (10) von der Wellenlänge und/oder der Intensität des einfallenden Lichtes (Li) abhängt.

10. Schaltungsanordnung (100) gemäß mindestens einem der Ansprüche 1 bis 9,
**dadurch gekennzeichnet,**
- **dass** in der Komparatoreinheit (20) mindestens eine Auswerteeinheit (30) implementiert und/oder integriert ist oder
- **dass** der Komparatoreinheit (20) mindestens eine Auswerteeinheit (30) nachgeschaltet ist.

11. Schaltungsanordnung (100) gemäß Anspruch 10,
**dadurch gekennzeichnet,**
**dass** die Auswerteeinheit (30) die Fehlermeldung generiert, wenn die Ausgangsspannung (Vₐᵤₛ) der Detektoreinheit (10) vom Sollbereich abweicht.

12. Schaltungsanordnung (100) gemäß mindestens einem der Ansprüche 1 bis 11,
**dadurch gekennzeichnet, dass**
- der Arbeitspunkt der Detektoreinheit (10) und/oder
- der Schwellenwert der Referenzspannung (V_{ref}) einstellbar ist.

13. Schaltungsanordnung (100) gemäß mindestens einem der Ansprüche 1 bis 12,
**dadurch gekennzeichnet, dass**
- innerhalb der Chipanordnung (200) und/oder
- lateral zur Chipanordnung (200) und/oder
- auf der Chipanordnung (200)
mindestens eine zum Schützen der Chipanordnung (200) vor äußeren Einflüssen vorgesehene, vorzugsweise schwer entfernbare dielektrische Abdeckung, insbesondere Isolierungsschicht und/oder Passivierungsschicht und/oder weitere Schutzschicht, angeordnet ist.

14. Schaltungsanordnung (100) gemäß Anspruch 13,
**dadurch gekennzeichnet,**
**dass** das Material der dielektrischen Abdeckung Epoxidharz oder Siliziumnitrit (SiNO₂) oder Siliziumdioxid (SiO₂) oder andere in der Halbleiterfertigung verwendete Isoliermaterialien aufweist.

15. Schaltungsanordnung (100) gemäß Anspruch 13 oder 14,
**dadurch gekennzeichnet,**
**dass** das Material der dielektrischen Abdeckung im wesentlichen lichtundurchlässig ausgebildet ist.

16. Schaltungsanordnung (100) gemäß mindestens einem der Ansprüche 1 bis 15,
**dadurch gekennzeichnet,**
**dass** die Chipanordnung (200) auf mindestens einem insbesondere schichtförmigen Trägersubstrat aus halbleitendem oder isolierendem Material angeordnet ist.

17. Schaltungsanordnung (100) gemäß mindestens einem der Ansprüche 1 bis 16,
**dadurch gekennzeichnet,**
**dass** die Schaltungsanordnung (100) in mindestens einer Karte, insbesondere in mindestens einer Chipkarte oder in mindestens einer Smart Card, implementiert und/oder integriert ist.

18. Karte, insbesondere Chipkarte oder Smart Card, aufweisend mindestens eine elektrische oder elektronische Schaltungsanordnung (100) gemäß mindestens einem der Ansprüche 1 bis 17.

19. Chipanordnung (200), beispielsweise (Halbleiter-)Chipanordnung, insbesondere Controllerchipanordnung für eine Chipkarte oder Smart Card, aufweisend
- mindestens eine, vorzugsweise mehrere oder viele insbesondere optosensitive Detektoreinheiten (10) gemäß mindestens einem der Ansprüche 1 bis 20; und
- mindestens eine Verknüpfungslogikeinheit (40) zum Verknüpfen der Detektoreinheiten (10).

20. Chipanordnung (200) gemäß Anspruch 19,
**dadurch gekennzeichnet,**
**dass** die Verknüpfungslogikeinheit (40) mit mindestens einer Kontrolllogikeinheit (50) in Verbindung steht.

21. Chipanordnung (200) gemäß Anspruch 19 oder 20,
**dadurch gekennzeichnet,**
**dass** die Verknüpfungslogikeinheit (40) mit mindestens einer insbesondere elektrisch löschbaren Speichereinheit (60) in Verbindung steht.

22. Chipanordnung (200) gemäß Anspruch 21,
**dadurch gekennzeichnet,**
- **dass** die Speichereinheit (60) als mindestens eine EEPROM-Speichereinheit (60') ausgebildet ist (EEPROM = Electrically Erasable Programmable Read-Only Memory = elektrisch löschbarer, programmierbarer Festwertspeicher) und
- **dass** die zu schützenden Daten und/oder Funktionen der Chipanordnung (200) bei Vorliegen einer insbesondere beim Vergleichen der Ausgangsspannung (Vₐᵤₛ) der Detektoreinheit (10) mit der Referenzspannung (V_{ref}) auftretenden Fehlermeldung mittels der EEPROM-Speichereinheit (60') löschbar (L) sind.

23. Chipanordnung (200) gemäß Anspruch 20 und gemäß Anspruch 21 oder 22,
**dadurch gekennzeichnet,**
- **dass** die Speichereinheit (60) zwischen die Verknüpfungslogikeinheit (40) und die Kontrolllogikeinheit (50) geschaltet ist und
- **dass** der Zugriff auf die zu schützenden Daten und/oder Funktionen der Chipanordnung (200) bei Vorliegen einer insbesondere beim Vergleichen der Ausgangsspannung (Vₐᵤₛ) der Detektoreinheit (10) mit der Referenzspannung (V_{ref}) auftretenden Fehlermeldung mittels Sperren (S) der Speichereinheit (60) sperrbar ist.

24. Chipanordnung (200) gemäß mindestens einem der Ansprüche 19 bis 23,
**dadurch gekennzeichnet,**
**dass** die Chipanordnung (200) über die Versorgungsspannung (V_{dd}), insbesondere über die Versorgungsanschlüsse der Chipanordnung (200), dauerhaft kurzschließbar ist.

25. Verfahren zum Schützen mindestens einer Chipanordnung (200), beispielsweise mindestens einer (Halbleiter-)Chipanordnung, insbesondere mindestens einer Controllerchipanordnung für eine Chipkarte oder Smart Card, vor Manipulation und/oder vor Missbrauch,
**dadurch gekennzeichnet,**
- **dass** in mindestens einer insbesondere optosensitiwn Detektoreinheit (10), insbesondere in mindestens einem bipolaren Transistor (12), eine durch auf die Detektoreinheit (10) einfallendes Licht (Li) bestimmte Ausgangsspannung (Vₐᵤₛ) generiert wird;
- **dass** in mindestens einer der Detektoreinheit (10) nachgeschalteten Komparatoreinheit (20) die Ausgangsspannung (Vₐᵤₛ) der Detektoreinheit (10) mit einer Referenzspannung (V_{ref}) verglichen wird; und
- **dass** die zu schüttenden Daten und/oder Funktionen der Chipanordnung (200) temporär oder permanent blockiert und/oder gelöscht (L) und/oder gesperrt (S) und/oder unterbrochen werden, wenn beim Vergleichen der Ausgangsspannung (Vₐᵤₛ) der Detektoreinheit (10) mit der Referenzspannung (V_{ref}) eine Fehlermeldung generiert wird.

26. Verfahren gemäß Anspruch 25,
**dadurch gekennzeichnet,**
**dass** das auf die Detektoreinheit (10) einfallende Licht im wesentlichen mittels des Übergangs zwischen der Basis (122) des bipolaren Transistors (12) und dem Kollektor (126) des bipolaren Transistors (12) aufgenommen wird.

27. Verfahren gemäß Anspruch 25 oder 26,
**dadurch gekennzeichnet,**
**dass** in der Komparatoreinheit (20) die Fehlermeldung ausgelöst wird, wenn die Ausgangsspannung (Vₐᵤₛ) der Detektoreinheit (10) vom Sollbereich abweicht.

28. Verfahren gemäß mindestens einem der Ansprüche 25 bis 27,
**dadurch gekennzeichnet,**
**dass** das Auslösen der Fehlermeldung
- mittels des Arbeitspunkts der Detektoreinheit (10) und/oder
- mittels des Schwellenwerts der Referenzspannung (V_{ref}) eingestellt wird.

29. Verfahren gemäß mindestens einem der Ansprüche 25 bis 28,
**dadurch gekennzeichnet,**
**dass** die Fehlermeldung
- in mindestens einer in der Komparatoreinheit (20) implementierten und/oder integrierten Auswerteeinheit (30) oder
- in mindestens einer der Komparatoreinheit (20) nachgeschalteten Auswerteeinheit (30)
erzeugt wird.

30. Verfahren gemäß mindestens einem der Ansprüche 25 bis 29,
**dadurch gekennzeichnet,**
**dass** bei Auslösen der Fehlermeldung mindestens eine mit mindestens einer zum Verknüpfen der Detektoreinheiten (10) vorgesehenen Verknüpfungslogikeinheit (40) in Verbindung stehende Kontrolllogikeinheit (50) vorübergehend oder temporär gesperrt (S) wird.

31. Verfahren gemäß mindestens einem der Ansprüche 25 bis 29,
**dadurch gekennzeichnet,**
**dass** bei Auslösen der Fehlermeldung mindestens eine zwischen mindestens eine zum Verknüpfen der Detektoreinheiten (10) vorgesehene Verknüpfungslogikeinheit (40) und mindestens eine Kontrolllogikeinheit (50) geschaltete, elektrisch löschbare Speichereinheit (60) dauerhaft oder permanent gesperrt (S) wird.

32. Verfahren germäß Anspruch 31,
**dadurch gekennzeichnet,**
**dass** die Kontrolllogikeinheit (50) mittels mindestens eines "Reset" (RS) temporär oder permanent gesperrt (S) wird.

33. Verfahren gemäß mindestens einem der Ansprüche 25 bis 29,
**dadurch gekennzeichnet,**
**dass** bei Auslösen der Fehlermeldung mindestens eine mit mindestens einer zum Verknüpfen der Detektoreinheiten (10) vorgesehenen Verknüpfungslogikeinheit (40) in Verbindung stehende, insbesondere einmal elektrisch programmierbare Speichereinheit (60) dauerhaft oder permanent gesperrt (S) wird.

34. Verfahren gemäß Anspruch 33,
**dadurch gekennzeichnet,**
**dass** mittels der Speichereinheit (60) die Versorgungsspannung (V_{dd}) kurzgeschlossen wird, insbesondere die Versorgungsanschlüsse der Chipanordnung (200) kurzgeschlossen werden.

35. Verfahren gemäß mindestens einem der Ansprüche 25 bis 29,
**dadurch gekennzeichnet,**
**dass** bei Auslösen der Fehlermeldung die zu schützenden Daten und/oder Funktionen in mindestens einer mit mindestens einer zum Verknüpfen der Detektoreinheiten (10) vorgesehenen Verknüpfungslogikeinheit (40) in Verbindung stehenden EEPROM-Speichereinheit (60') gelöscht (L) werden (EEPROM = Electrically Erasable Programmable Read-Only Memory = elektrisch löschbarer, programmierbarer Festwertspeicher).
